# EUROPÄISCHE PATENTSCHRIFT

(11) **EP 2 251 914 B1**
(45) Veröffentlichungstag und Bekanntmachung des Hinweises auf die Patenterteilung: **27.04.2011**
(21) Anmeldenummer: 09004431.4
(22) Anmeldetag: 27.03.2009
(51) Int. Cl.: H01L 31/18, H01L 31/0216, H01L 31/068

(54) **Verfahren zum Aufbringen einer Anti-Reflexionsschicht auf einen Silizium-Wafer**
Method for applying an anti-reflection layer to a silicon wafer
Procédé destiné à l'application d'une couche anti-réflexion sur une tranche de silicium

(43) Veröffentlichungstag der Anmeldung: 17.11.2010
(73) Patentinhaber: KIOTO Photovoltaics GmbH, 9300 St. Veit (AT)
(72) Erfinder: Kröner, Friedrich, Dr., 9500 Villach (AT)
(74) Vertreter: Becker, Thomas

(56) Entgegenhaltungen:
- DE-A1- 1 521 093
- DE-A1- 2 013 576
- DE-A1- 3 340 874

## Beschreibung

Die Erfindung betrifft ein Verfahren zum Aufbringen einer Anti-Reflexionsschicht auf einen Silizium-Wafer und einen zugehörigen Silizium-Wafer

Ein gattungsgemäßer Silizium-Wafer, der später als Solarzelle in einer Fotovoltaik-Anlage Strom liefern soll, weist beispielsweise auf einer seiner Haupt-Oberflächen eine so genannte p-Dotierung des Siliziums auf, üblicherweise durch Elemente aus der dritten Hauptgruppe des Periodensystems (beispielsweise Bor, Indium, Aluminium oder Gallium). "Auf einer Oberfläche" inkludiert jeweils eine gewisse Penetrationstiefe senkrecht zur Haupt-Oberfläche.

Auf der gegenüberliegenden zweiten Hauptfläche des Wafers muss dann die genannte n-Dotierung aufgebracht werden. Dies erfolgt im Stand der Technik so, dass man aus einem geeigneten Gas bei hoher Temperatur Phosphor-Atome in die später der Sonne zugewandte Haupt-Oberfläche des Silizium-Wafers eindringen (diffundieren) lässt. Diese n-leitende Schicht ist üblicherweise extrem dünn, damit das Licht ungehindert bis zum pn-Übergang (zwischen der n-dotierten einen Haupt-Oberfläche und der p-dotierten anderen Haupt-Oberfläche) vordringen kann. Die Dicke der n-leitenden Schicht beträgt beispielsweise weniger als 0,001 mm, während der Wafer selbst eine Dicke (Abstand zwischen den Haupt-Oberflächen) von beispielsweise 0,1 bis 0,4 mm aufweist.

Der Nachteil der bekannten n-Dotierung besteht darin, dass zum Teil hochgiftige Gase, die Phosphin enthalten können, oder korrosive Gase wie POCl₃ verwendet werden und nur ein Teil des angebotenen Phosphors (meist weniger als 50 %) in die Solarzelle übergeht.

Aus dem Stand der Technik ist es weiters bekannt, die Solarzellen (Silizium-Wafer) auf ihrer n-dotierten Haupt-Oberfläche mit einer dünnen Schicht zu überziehen, die als Anti-Reflexionsschicht ausgebildet ist, um Verluste durch Reflektion des Lichtes zu reduzieren. Die Schicht wird beispielsweise in einem mit gasförmigem Ammoniak und Silanen gefüllten Vakuum-Reaktor bei Temperaturen zwischen 300 und 400°C aufgebracht.

Der Erfindung liegt die Aufgabe zu Grunde, einen Silizium-Wafer zur Verfügung zu stellen, der eine wirksame Anti-Reflexionsschicht aufweist und in einem einfachen Verfahren ohne Verwendung gefährlicher Gase hergestellt werden kann.

Grundgedanke der Erfindung ist es, die Anti-Reflexionsschicht mit Hilfe eines elektrochemischen (galvanischen) Prozesses auszubilden. Diese Verfahrenstechnik erlaubt es, gleichzeitig die n-Dotierung über einen elektrochemischen Prozess einzuleiten.

In einem einzigen Verfahrensschritt kann auf diese Weise ein Niederschlag auf der entsprechenden Haupt-Oberfläche erreicht werden, der anschließend bei einer thermischen Nachbehandlung sowohl die n-Dotierung im Oberflächenbereich als auch die Erstellung der Anti-Reflexionsschicht erlaubt.

Dabei wird es möglich, im Wesentlichen nur den Phosphoranteil an und in die Solarzelle zu bringen, der für die Dotierung benötigt wird. Das Verfahren weist den weiteren Vorteil auf, dass der Phosphor in Form von PhosphatIonen, also in oxidierter Form, vorliegt. Phosphor steht dabei stellvertretend für alle Elemente der 5. Hauptgruppe des Periodensystems als Dotierstoff zur Verfügung.

Ein wichtiges Merkmal ist, dass die Anti-Reflexionsschicht durch einen Anteil an Elementen der 5. Hauptgruppe des Periodensystems (neben der silikatischen Haupt-Komponente) hervorragende optische Eigenschaften in Hinblick auf die Vermeidung von Licht-Reflektionen hat, die zusätzlich durch die Schichtdicke variiert werden können.

In ihrer allgemeinsten Ausführungsform betrifft die Erfindung ein Verfahren zum Aufbringen einer Anti-Reflexionsschicht auf einen Silizium-Wafer mit den Schritten gemäß Anspruch 1.

Der DE 33 40 874 A1 ist ein Verfahren zur Herstellung einer Solarzelle zu entnehmen. Dabei wird eine erste Schicht als Diffusionsquelle zur Herstellung eines pn-Übergangs auf einen Halbleiterkörper aufgebracht und auf die erste Schicht erfolgt der Auftrag einer weiteren Schicht für die Herstellung einer Antireflexionsschicht.

Ein Silizium-Wafer, der mit dem erfindungsgemäßen Verfahren hergestellt werden kann, zeichnet sich durch folgende Merkmale aus:
- eine n-dotierten Haupt-Oberfläche,
- eine darauf angeordnete Anti-Reflexionsschicht, die
- eine Dicke von 50-250nm aufweist und
- aus einem Silikatglas mit Anteilen von Elementen aus der 5. Hauptgruppe des Periodensystems besteht.

Die Anti-Reflexionsschicht sollte rotes Licht zu mehr als 90% absorbieren, was mit einem Glas auf Basis SiO₂ und P₂O₅ möglich ist. Dabei beträgt der SiO₂-Anteil am besten über 80 Masse-%.

Nach einer Ausführungsform wird bei dem erfindungsgemäßen Verfahren die Verweilzeit des Silizium-Wafers im Becken und im Ofen so gewählt, dass die Anti-Reflexionsschicht eine Dicke von über 150nm und/oder die n-dotierte Haupt-Oberfläche eine Dicke (senkrecht zur Haupt-Oberfläche) von 100-1000nm aufweist.

Mit dem skizzierten ersten Verfahrensschritt (fluiddichte Abdeckung einer Haupt-Oberfläche) wird sichergestellt, dass bei der anschließenden elektrochemischen Behandlung nur die verbleibende Oberfläche in Wechselwirkung mit der Lösung tritt. Dabei kann die Abdichtung mit einem Element erfolgen, welches bis auf Saugstellen vollflächig gegen den Silicium-Wafer anliegt und die Anodenfunktion übernimmt.

Der Wafer wird im nächsten Verfahrensschritt in einem Becken in die genannte Lösung eingetaucht, die mindestens 2 Komponenten enthält: Silikat-Ionen, die für die spätere Ausbildung der Anti-Reflexionsschicht wesentlich sind und Dotier-Ionen, die der n-Dotierung der nicht abgedeckten Haupt-Oberfläche des Wafers dienen. Die Silikat-Ionen sind Anionen der Kieselsäure und/oder Anionen von Salzen der Kieselsäure (wie Wasserglas).

Die elektrochemische Abscheidung (der beispielsweise wässrigen Elektrolyten) aus der Lösung auf der nicht abgedeckten Haupt-Oberfläche des Wafers erfolgt durch Stromdurchgang. Dabei ist das Substrat (der Silizium-Wafer) als Anode geschaltet und im Becken ist eine Gegenelektrode (Kathode) angeordnet.

Die Verweilzeit des Wafers im Becken richtet sich nach dem Grad der gewünschten (anodischen) Abscheidung der Silikat- und Dotierionen. In der Regel wird der Prozess bis zur Ausbildung einer temporären Schichtdicke von 100 bis 300nm durchgeführt.

Danach wird der Wafer mit dem Elektrolyt-Niederschlag auf seiner Haupt-Oberfläche aus dem Becken entnommenen, getrocknet und insbesondere in einem Ofen thermisch auf eine Temperatur über 700° C erwärmt (gebrannt), um die gewünschte Menge an Dotier-Atomen in das Silizium-Gitter des Wafers einzubauen. Gleichzeitig bildet sich auf der Oberfläche des Silizium-Wafers die gewünschte glasige Anti-Reflexionsschicht aus.

Als Dotier-Atome innerhalb der fünften Hauptgruppe des Periodensystems sind insbesondere Phosphor-Atome geeignet.

Das Verfahren kann durch Zugabe eines Reaktionsbeschleunigers in die galvanische Lösung optimiert werden. Der Reaktionsbeschleuniger umfasst beispielsweise Titanat-Ionen, die als Tetraethyl-Orthotitanat eingebracht werden können, oder Trinatriumcitrat.

Üblicherweise beträgt die Verweilzeit des Wafers im Becken zwischen 2 und 10 Minuten, wobei sich eine Verweildauer von 4 bis 6 Minuten als günstig herausgestellt hat, ausgehend von einer Spannung zwischen 10 und 30 Volt und einem Stromfluss zwischen 25 und 150 mA/dm², wobei 30 bis 100 mA/dm² für den gewünschten Effekt genügen.

Nach der Entnahme des Wafers aus dem Becken sollte der überschüssige wässrige Elektrolyt zunächst ablaufen, bevor der eigentliche Trocknungsvorgang beginnt, der üblicherweise zwischen 0,5 und 5 Minuten dauert. Der Trocknungsvorgang kann in einem vorgeheizten Raum beschleunigt werden.

Zur Trocknung können beispielsweise elektrische Wärmestrahler verwendet werden. Die Trocknung erfolgt dann durch Strahlung. Wärmestrahler mit einer Leistung zwischen 250 und 750 Watt reichen aus, um die gewünschte Trocknung innerhalb des genannten Zeitraums zu erreichen.

Die Trocknung kann auch mit dem abschließenden Verfahrensschritt kombiniert werden, bei dem die eigentliche Dotierung und Ausbildung einer Glasur-Oberfläche auf dem Wafer erfolgt. Dazu ist eine Umgebungstemperatur von über 700° C erforderlich, wobei Temperaturen zwischen 800 und 1100° C sich als günstig herausgestellt haben. Ausgehend von diesem Temperaturintervall beträgt die Verweildauer der Wafer im Ofen üblicherweise 10 bis 30 Minuten, beispielsweise 15 bis 25 Minuten. Durch Einstellung der Dauer und Temperatur wird die gewünschte Menge an Dotier-Ionen in das Silizium-Gitter des Silizium-Wafers eingebaut, bis das Silizium-Gitter die gewünschte Dichte an Dotier-Atomen aufweist und die glasige Anti-Reflexionsschicht ausgebildet ist.

Soweit ein auf der anderen Haupt-Oberfläche bereits p-dotierter Wafer verwendet wird, ist der Dotierungsvorgang danach abgeschlossen. Andernfalls muss in einem separaten Arbeitsschritt die p-Dotierung (Rückseitendotierung) anschließend erfolgen, beispielsweise durch elektrochemische Abscheidung von Borsäure und durch eine borhältige Silikatglasabscheidung.

Um die durch den so genannten Sperrschicht-Effekt entstehende Spannung von beiden Seiten der Solarzelle abgreifen zu können, müssen auf der Vorder- und Rückseite Metallkontakte aufgebracht werden. Die Aufbringung der Metallkontakte gehört nicht zum gegenständlichen Verfahren. Sie wird lediglich der Vollständigkeit halber nachstehend kurz behandelt:
Auf der Vorderseite, das ist die n-dotierte Haupt-Oberfläche des Wafers, wird dazu ein Metallgitter aufgebracht, und zwar an den Stellen, an denen zuvor die Anti-Reflexionsschicht wieder entfernt wurde. Das Metallgitter besteht üblicherweise aus einzelnen Leiterbahnen, die sich zu einer Leiterbahn-Struktur ergänzen und eine erste Elektrode bilden, während die zweite Haupt-Oberfläche, also die p-dotierte Haupt-Oberfläche, als zweite Elektrode mit entgegengesetzter Polarität ausgebildet wird. Dies kann vollflächig erfolgen. Die Leiterbahnen sollen einerseits die optimale Ausnutzung der Oberfläche für die Stromgewinnung sicherstellen und andererseits so wenig wie möglich den Lichteinfall in die Solarzelle behindern. Deshalb besteht die Leiterbahn-Struktur häufig aus zwei oder drei so genannten Busbars (Lötkontakten) die sich parallel und im Abstand zueinander über die Haupt-Oberfläche erstrecken und einer Vielzahl von senkrecht dazu verlaufenden schmalen Leiterbahnen (sogenannten Fingern), die in den jeweils zugeordneten Busbar einmünden und mit diesem elektrisch verbunden sind.

Auf der Rückseite (p-dotierter Haupt-Oberfläche) können entsprechende Lötkontakte (Busbars) aufgebracht werden.

Mehrere so ausgebildete Solarzellen werden zu einem so genannten String über entsprechende Lötbänder verbunden. Dabei sind die einzelnen Wafer in Serie geschaltet.

## Patentansprüche

1. Verfahren zum Aufbringen einer Anti-Reflexionsschicht auf einen Silizium-Wafer mit folgenden Schritten:
1.1 eine erste Haupt-Oberfläche des Wafers wird fluiddicht abgedeckt,
1.2 der Wafer wird danach in ein Becken eingetaucht, welches eine Lösung auf Basis von Anionen der Kieselsäure und/oder von Anionen mindestens eines Salzes der Kieselsäure sowie Dotier-Ionen mindestens eines Elements der 5. Hauptgruppe des Periodensystems enthält,
1.3 zur elektrochemischen Abscheidung der Anionen auf der nicht abgedeckten, zweiten Hauptoberfläche des Wafers wird zwischen dem als Anode geschalteten Wafer und einer als Kathode geschalteten weiteren Elektrode Gleichstrom angelegt,
1.4 nach einer Verweilzeit im Becken wird der Wafer aus dem Becken entnommen und
1.5 anschließend getrocknet sowie bei einer Temperatur über 700°C gebrannt, bis eine gewünschte Menge an Dotier-Atomen in das Silizium-Gitter des Wafers eingebaut ist und sich auf der zweiten Haupt-Oberfläche des Silizium-Wafers eine glasartige Anti-Reflexionsschicht ausgebildet hat.

2. Verfahren nach Anspruch 1, bei dem die Verweilzeit des Silizium-Wafers im Becken und im Ofen so gewählt wird, dass die Anti-Reflexionsschicht eine Dicke von 50-250 nm aufweist.

3. Verfahren nach Anspruch 1, bei dem die Dotier-Ionen Phosphor-Ionen sind.

4. Verfahren nach Anspruch 1, bei dem die Verweilzeit des Silizium-Wafers in der Lösung 2 bis 10 Minuten beträgt.

5. Verfahren nach Anspruch 1, bei dem die elektrochemische Abscheidung bei einer Stromstärke von 50-150 mA/dm² erfolgt.

6. Verfahren nach Anspruch 1, bei dem der Silizium- Wafer in einem Ofen bei einer Temperatur zwischen 800 und 1100° gebrannt wird.

## Claims

1. Method for applying an anti-reflection coating to a silicon wafer comprising the following steps:
1.1 a first main surface of the wafer is coated in a fluid-tight manner,
1.2 the wafer is then immersed in a tank which contains a solution based on silicic acid anions and/or anions of at least one silicic acid salt and doping ions of at least one element of the 5th main group of the Periodic Table,
1.3 for the electrochemical deposition of the anions on the non-coated, second main surface of the wafer, direct current is applied between the wafer connected in the form of an anode and a further electrode connected in the form of a cathode,
1.4 the wafer is removed from the tank after a residence time in the tank and
1.5 subsequently dried and baked at a temperature of over 700°C until a desired quantity of doping atoms is inserted into the silicon lattice of the wafer and a glassy anti-reflection coating has formed on the second main surface of the silicon wafer.

2. Method according to Claim 1, in which the residence time of the silicon wafer in the tank and in the furnace is selected so that the anti-reflection coating has a thickness of 50 - 250 nm.

3. Method according to Claim 1, in which the doping ions are phosphorus ions.

4. Method according to Claim 1, in which the residence time of the silicon wafer in the solution is 2 to 10 minutes.

5. Method according to Claim 1, in which the electrochemical deposition takes place at a current intensity of 50 - 150 mA/dm².

6. Method according to Claim 1, in which the silicon wafer is baked in a furnace at a temperature of between 800 and 1100°C.

## Revendications

1. Procédé pour l'application d'une couche antireflets sur une tranche de silicium comprenant les étapes suivantes :
1.1 une première surface principale de tranche est recouverte de façon étanche au fluide,
1.2 la tranche est plongée ensuite dans un bassin qui contient une solution à base d'anions d'acide silique et/ou d'anions d' au moins un sel d'acide silique ainsi que d'ions de dopage d'au moins un élément du 5^{ème} groupe principal du système périodique,
1.3 pour la précipitation électrochimique des anions sur la seconde surface principale non-recouverte de la tranche, du courant continu est appliqué entre la tranche branchée comme anode et une autre électrode branchée comme cathode,
1.4 après un temps de séjour dans le bassin, la tranche est sortie du bassin et
1.5 séchée ensuite et cuite à une température supérieure à 700°C, jusqu'à ce qu'une quantité souhaitée d'atomes de dopage soit intégrée dans la grille de silicium de la tranche et une couche antireflets vitreuse s'est formée sur la seconde surface principale de la tranche de silicium.

2. Procédé selon la revendication 1, dans lequel le temps de séjour de la tranche de silicium dans le bassin et dans le four est choisi de telle sorte que la couche antireflets présente une épaisseur de 50 à 250 nm.

3. Procédé selon la revendication 1, dans lequel les ions de dopage sont des ions de phosphore.

4. Procédé selon la revendication 1, dans lequel le temps de séjour de la tranche de silicium dans la solution est de 2 à 10 minutes.

5. Procédé selon la revendication 1, dans lequel la précipitation électrochimique s'effectue avec une intensité de courant de 50 à 150 mA/dm².

6. Procédé selon la revendication 1, dans lequel la tranche de silicium est cuite dans un four à une température comprise entre 800 et 1100°C.
